# EUROPEAN PATENT APPLICATION

(11) **EP 4 797 906 A1**
(43) Date of publication of application: **26.08.2026**
(21) Application number: 25221170.1
(22) Date of filing: 05.12.2025
(51) Int. Cl.: H10F 10/14, H10F 10/165, H10F 77/14, H10F 77/70

(54) **SOLAR CELL AND PREPARATION METHOD THEREFOR, AND PHOTOVOLTAIC MODULE**

(30) Priority: 25.02.2025 CN 202510206251
(71) Applicant: Tongwei Solar (Chengdu) Co., Ltd., Chengdu, Sichuan 610299 (CN)
(72) Inventor: CHEN, Yang, Chengdu, 610299 (CN); MENG, Xiajie, Chengdu, 610299 (CN); FAN, Jianbin, Chengdu, 610299 (CN); YANG, Tao, Chengdu, 610299 (CN)
(74) Representative: Murgitroyd & Company

(57) **Abstract**

The present application provides a solar cell and a preparing method therefor, and a photovoltaic module, relating to the field of photovoltaic technologies. The solar cell provided in the present application includes a silicon substrate (100) and a film-layer structure disposed on a surface of the silicon substrate (100). At least a portion, covered by the film-layer structure, of the surface of the silicon substrate (100) is provided with a plurality of microstructure units, and each microstructure unit of at least a portion of the plurality of microstructure units includes at least two substructures. The plurality of microstructure units may form a surface with certain undulations, thereby increasing a bonding area between the film-layer structure and the silicon substrate (100), and reducing a contact resistivity of the film-layer structure.

## Description

### TECHNICAL FIELD

The present application relates to the field of photovoltaic technologies, and in particular, to a solar cell and a preparing method therefor, and a photovoltaic module.

### BACKGROUND

Generally, a solar cell includes a silicon substrate and a film-layer structure disposed on the silicon substrate. The film-layer structure is configured to transport carriers. Bonding quality between the film layers and a surface of the silicon substrate, and quality of the film layers affect performance of the solar cell. For example, a p-type doped layer and an n-type doped layer are in contact with a back side of the silicon substrate through a dielectric layer (such as an oxide dielectric layer). A contact resistivity between the dielectric layer and the silicon substrate affects a photoelectric conversion efficiency of a solar cell. A passivation layer is directly attached to the surface of the silicon substrate or covers an outer side of a doped layer, and quality of the passivation layer affects passivation performance, thereby influencing the photoelectric conversion efficiency of the solar cell.

### SUMMARY

The present application provides a solar cell and a preparing method therefor, and a photovoltaic module. The solar cell and a solar cell prepared by the preparing method exhibit better photoelectric conversion efficiency.

Embodiments of the present application may be implemented as follows:

In a first aspect, the present application provides a solar cell, including: a silicon substrate provided with a light-receiving side and a back side opposite to each other in a thickness direction of the silicon substrate; and a film-layer structure disposed on a surface of the back side of the silicon substrate, at least a portion, covered by the film-layer structure, of a surface of the silicon substrate being provided with a plurality of microstructure units, the plurality of microstructure units including at least one first microstructure unit, and each first microstructure unit of the at least one first microstructure unit being provided with at least two substructures. In a case that the solar cell is a back-contact solar cell, the surface of the back side of the silicon substrate includes an n-type doped region and a p-type doped region, and the first microstructure unit is located in the n-type doped region; or in a case that the solar cell is a TOPCon solar cell, the surface of the back side of the silicon substrate includes a metallized region and a non-metallized region, and the first microstructure unit is located in the non-metallized region.

In one or more embodiments, in the first microstructure unit, an interface of each two of the at least two substructures is presented on a top surface, facing towards a side of the film-layer structure, of the first microstructure unit.

In one or more embodiments, a projection pattern of the microstructure unit on a preset plane is a polygon or a polygon-liked, and a perimeter of the projection pattern of the microstructure unit on the preset plane ranges from 10 µm to 500 µm, where the preset plane is parallel to a plane of the silicon substrate.

In one or more embodiments, the projection pattern of the substructure on a preset plane is a polygon or a polygon-like, and a perimeter of the projection pattern of the substructure on the preset plane ranges from 1 µm to 100 µm, where the preset plane is parallel to a plane of the silicon substrate.

In one or more embodiments, each first microstructure unit includes 2 to 30 substructures.

In one or more embodiments, in the first microstructure unit, a plurality of substructures are arranged along a straight line direction, or a plurality of substructures are randomly arranged, or a plurality of substructures are arranged around a periphery of the first microstructure unit to form a cluster, or a plurality of substructures are randomly arranged.

In one or more embodiments, at least a portion of the plurality of microstructure units are adjacent to each other on a preset plane; and/or at least a portion of the plurality of microstructure units partially overlap each other in a thickness direction of the substrate; where the preset plane is parallel to the silicon substrate.

In one or more embodiments, the solar cell is the back contact solar cell, and the n-type doped region and the p-type doped region are separated by a trench; and the film-layer structure includes a p-type doped layer, an n-type doped layer, a first dielectric layer, and a second dielectric layer, the first dielectric layer and the p-type doped layer are stacked on the p-type doped region in sequence, the second dielectric layer and the n-type doped layer are stacked on the n-type doped region in sequence, and the first microstructure unit is located in the n-type doped region.

In one or more embodiments, first passivation layers are disposed on the light-receiving side of the silicon substrate, and second passivation layers are disposed at a bottom of the trench, on a side of the p-type doped layer far away from the silicon substrate, and on a side of the n-type doped layer far away from the silicon substrate.

In one or more embodiments, materials of the first passivation layers and the second passivation layers are selected from at least one of aluminum oxide (AlOx), silicon oxide (SiOx), silicon nitride (SiNx), or silicon oxynitride (SiOxNy).

In one or more embodiments, the solar cell is the TOPCon solar cell, the film-layer structure includes a p-type doped layer, an n-type doped layer, and a dielectric layer; the p-type doped layer is disposed on a light-receiving side of the silicon substrate, and the dielectric layer and the n-type doped layer are stacked on the metallized region in sequence.

In one or more embodiments, a first passivation layer is located on a side of the p-type doped layer away from the silicon substrate, and second passivation layers are located at a back side of the non-metallized region, and on a side of the n-type doped layer far away from the silicon substrate.

In one or more embodiments, materials of the first passivation layer and the second passivation layer are selected from at least one of aluminum oxide (AlOx), silicon oxide (SiOx), silicon nitride (SiNx), or silicon oxynitride (SiOxNy).

In a second aspect, the present application provides a preparing method for a solar cell, including:
polishing a surface of a silicon substrate by wet etching to form a plurality of microstructure units; and
depositing a film-layer structure on the silicon substrate, before or during a process of depositing the film-layer structure, scanning at least a portion of the surface of the silicon substrate with a laser, so that at least one of the plurality of microstructure units forms a first microstructure unit provided with at least two substructures, and the first microstructure unit is covered by the film-layer structure subsequent to completing the preparation of the film-layer structure .

In one or more embodiments, the silicon substrate is provided with a light-receiving side and a back side opposite to each other in a thickness direction of the silicon substrate, where the film-layer structure is deposited on the silicon substrate; before or during the deposition process steps of the film-layer structure, at least a portion of the surface of the silicon substrate is scanned with the laser, enabling at least one of the plurality of microstructure units to form the first microstructure unit which includes at least two substructures, where the process steps including:
depositing a first dielectric layer and a p-type doped layer on the back side of the silicon substrate in sequence;
removing a portion of the first dielectric layer and a portion of the p-type doped layer using a first laser to expose a portion of the surface of the silicon substrate;
performing laser irradiation on an exposed surface of the silicon substrate using a second laser, enabling at least one of the plurality of microstructure units on the exposed surface of the silicon substrate to form the first microstructure unit which includes at least two substructures;
depositing a second dielectric layer and an n-type doped layer on the exposed surface of the silicon substrate in sequence;
etching and forming a trench using a third laser to separate the p-type doped layer from the n-type doped layer, where the trench extending into the silicon substrate; and
depositing first passivation layers on the light-receiving side of the silicon substrate, and depositing second passivation layers on a side of the n-type doped layer away from the silicon substrate, on a side of the p-type doped layer away from the silicon substrate, and at a bottommost of the trench.

In one or more embodiments, the silicon substrate is provided with a light-receiving side and a back side opposite to each other in a thickness direction of the silicon substrate, where the depositing the film-layer structure on the silicon substrate, before or during the process of depositing the film-layer structure, performing laser irradiation on at least a portion of the surface of the silicon substrate, so that at least one of the plurality of microstructure units forms the first microstructure unit provided with at least two substructures includes:
depositing a p-type doped layer on the light-receiving side of the silicon substrate;
depositing a dielectric layer and an n-type doped layer on the back side of the silicon substrate in sequence;
removing a portion of the dielectric layer and a portion of the n-type doped layer using a first laser to expose a non-metallized region of the silicon substrate;
performing laser irradiation on the non-metallized region using a second laser, so that at least one of the plurality of microstructure units in the non-metallized region forms the first microstructure unit provided with at least two substructures; and
depositing a first passivation layer on a side of the p-type doped layer away from the silicon substrate, and depositing second passivation layers on the non-metallized region and on a side of the n-type doped layer away from the silicon substrate.

In one or more embodiments, the first laser is selected from any of a nanosecond laser, a picosecond laser, or a femtosecond laser, where a laser wavelength ranges from 200 nm to 1300 nm, and an laser energy density of the first laser ranges from 100 mJ/cm² to 600 mJ/cm²; and/or, the second laser is selected from any of an ultraviolet picosecond laser or an ultraviolet femtosecond laser, where an energy density of the second laser ranges from 20 mJ/cm² to 100 mJ/cm².

### BRIEF DESCRIPTION OF THE DRAWINGS

To more clearly illustrate technical solutions of the embodiments of the present application, drawings that are required to be used in the embodiments will be briefly introduced below. It should be understood that drawings in the following description are some embodiments of the present application, and therefore should not be considered as a limitation on the scope. For those with ordinary skill in the art, other related drawings may be obtained according to structures shown in these drawings without creative work.
FIG. 1 is a schematic diagram of a solar cell provided by the embodiments of the present application.
FIG. 2 is a microscopic image of a surface of a silicon substrate provided by the embodiments of the present application.
FIG. 3 is a microscopic image of a microstructure unit provided by the embodiments of the present application.
FIG. 4 is a schematic diagram of a microstructure unit and a substructure contained herein provided by the embodiments of the present application.
FIG. 5 is a schematic diagram of a first test structure provided by the present application.
FIG. 6 shows a comparison of i-Voc performance upon a first test structure being applied bewteen a silicon substrate with a substructure and a silicon substrate without a substructure.
FIG. 7 is a schematic diagram of a second test structure provided by the present application.
FIG. 8 shows a comparison performance upon a second test structure being applied bewteen a silicon substrate with a substructure and a silicon substrate without a substructure.
FIG. 9 is a schematic diagram of a third test structure provided by the present application.
FIG. 10 shows a comparison performance upon a third test structure being applied bewteen a silicon substrate with a substructure and a silicon substrate without a substructure.
FIG. 11 is a schematic diagram of a solar cell provided by embodiments of the present application.
FIG. 12 is a flowchart of a preparing method for a solar cell provided by embodiments of the present application.
FIG. 13 is a schematic diagram of a structure after preparing a first dielectric layer and a p-type doped layer on a silicon substrate provided by embodiments of the present application.
FIG. 14 is a schematic diagram of a structure after removing a portion of a first dielectric layer and a portion of a p-type doped layer provided by embodiments of the present application.
FIG. 15 is a schematic diagram of a structure after preparing a second dielectric layer and an n-type doped layer provided by embodiments of the present application.
FIG. 16 is a schematic diagram of a structure after being etched by a third laser to form a trench in embodiments of the present application.
FIG. 17 is a schematic diagram of a structure after preparing a first passivation layer and a second passivation layer provided by embodiments of the present application.

Reference numerals: 100-silicon substrate; 101-first surface; 102-second surface; 103-trench; 200-dielectric layer; 210-first dielectric layer; 220-second dielectric layer; 300-p-type doped layer; 400-n-type doped layer; 500-passivation layer; 510-first passivation layer; 520-second passivation layer; 600-electrode; 610-first electrode; 620-second electrode.

### DETAILED DESCRIPTION OF THE EMBODIMENTS

To make objectives, technical solutions, and advantages of the embodiments of the present application clearer, the technical solutions in the embodiments of the present application will be clearly and completely described with reference to drawings in the embodiments of the present application. Apparently, the described embodiments are a portion of the embodiments of the present application, rather than all of the embodiments. Components of the embodiments of the present application described and illustrated in the drawings herein may be arranged and designed in various different configurations.

Therefore, detailed description of the embodiments of the present application provided in the drawings is not intended to limit the scope of the claimed application, but merely represents selected embodiments of the present application. Based on the embodiments of the present application, all other embodiments obtained by those with ordinary skill in the art without creative work shall fall within the protection scope of the present application.

It should be noted that similar reference numerals and letters in following drawings indicate similar items. Therefore, once an item is defined in a drawing, it does not need to be further defined and explained in subsequent drawings.

In the description of the present application, it should be noted that directional or positional terms such as "upper", "lower", "inner", "outer", and the like, are based on orientation or positional relationships shown in the drawings, or conventional orientation or positional relationships when an invented product is used. These terms are merely for facilitating the description of the present application and simplifying the description, rather than indicating or implying that an apparatus or an element referred to must have a specific orientation, or be constructed and operated in a specific orientation, and therefore should not be construed as limiting the present application.

In addition, terms such as "first", "second", and the like, are only used for distinguishing the description and cannot be understood as indicating or implying relative importance.

It should be noted that, in the absence of conflict, features in the embodiments of the present application may be combined with each other.

As mentioned above, the solar cell in the related art still suffer from issues such as high contact resistivity between a film-layer structure and a silicon substrate, and insufficient passivation performance. Occurrence of these issues is related to a surface morphology of the silicon substrate. Thereby, the embodiments of the present application provide a solar cell and a preparing method therefor. By forming a microstructure unit containing a substructure on the silicon substrate, contact performance between the film-layer structure and the silicon substrate is optimized, thereby improving photoelectric conversion efficiency of the solar cell.

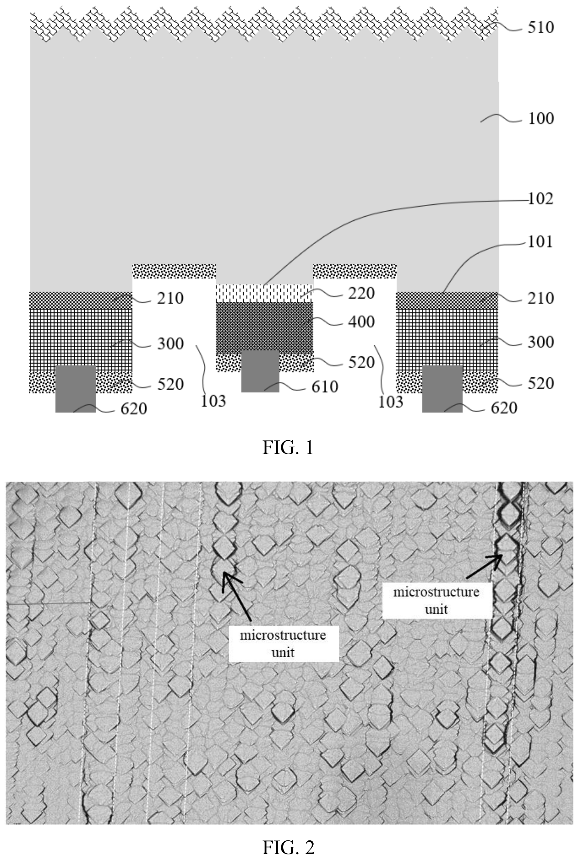

FIG. 1 is a schematic diagram of a solar cell provided by a first embodiment of the present application. As shown in FIG. 1, the solar cell provided in this embodiment is a back contact solar cell, also known as a BC solar cell. The solar cell includes a silicon substrate 100, a film-layer structure disposed on a surface of the silicon substrate 100, and an electrode 600 connected to the film-layer structure. In this embodiment, the silicon substrate 100 is provided with a light-receiving side and a back side opposite to each other in a thickness direction of the silicon substrate 100. As shown in FIG. 1, the light-receiving side is a side of the silicon substrate 100 facing upward, and the back side is a side of the silicon substrate 100 facing downward. The film-layer structure includes a p-type doped layer 300, an n-type doped layer 400, a first dielectric layer 210, a second dielectric layer 220, a first passivation layer 510, and a second passivation layer 520. The first passivation layer 510 is disposed on the light-receiving side of the silicon substrate 100. The first dielectric layer 210 and the p-type doped layer 300 are stacked on a first surface 101 in sequence, and the first dielectric layer 210 is located between the first surface 101 and the p-type doped layer 300. The second dielectric layer 220 and the n-type doped layer 400 are stacked on a second surface 102 in sequence, and the second dielectric layer 220 is located between the second surface 102 and the n-type doped layer 400. The second passivation layers 520 are disposed on a side of the p-type doped layer 300 far away from the silicon substrate 100 and on a side of the n-type doped layer 400 away from the silicon substrate 100.

Furthermore, the electrode 600 includes a first electrode 610 and a second electrode 620, where the first electrode 610 is connected to the p-type doped layer 300, and the second electrode 620 is connected to the n-type doped layer 400. In this embodiment, the light-receiving side of the silicon substrate 100 corresponds to a light-receiving side of the solar cell, and the back side of the silicon substrate 100 corresponds to a back side of the solar cell. A characteristic of the back contact solar cell is that the electrode 600 is not disposed on the light-receiving side, and all electrodes 600 are disposed on the back side. Therefore, an entire area of the light-receiving side of the back contact solar cell is capable of receiving sunlight, which enables the back contact solar cell a higher photoelectric conversion efficiency.

In the present application, at least a portion, covered by the film-layer structure, of the surface of the silicon substrate 100 is provided with a plurality of microstructure units, and each microstructure unit of at least a portion of the plurality of microstructure units is provided with at least two substructures. Exemplarily, in the present application, each microstructure unit with substructures may be defined as a first microstructure unit, that is, the plurality of microstructure units include at least one first microstructure unit, and each first microstructure unit of the at least one first microstructure unit is provided with at least two substructures. In the present application, a back side of the silicon substrate 100 (that is, a surface of the back side) includes an n-type doped region (corresponding to the first surface 101) and a p-type doped region (corresponding to the second surface 102), the p-type doped region is covered by a p-type doped layer 300, and the n-type doped region is covered by an n-type doped layer 400. Among them, the n-type doped region is provided with the first microstructure unit.

Furthermore, an interface between each two of the at least two substructures is presented on a top surface of the microstructure unit. It should be understood that when the film-layer structure is in contact with a top surface of the first microstructure unit along the thickness direction of the silicon substrate 100, the film-layer structure is in contact with at least two substructures in a same first microstructure unit and an interface between them. A interface of two adjacent substructures forms a recess on the top surface of the first microstructure unit. Therefore, due to presence of the substructures, a side of the first microstructure unit in contact with the film-layer structure becomes rougher and has a larger surface area, which is beneficial to reduce a contact resistivity between the film-layer structure and the first microstructure unit, and improve a passivation effect of the film-layer structure. Optionally, one first microstructure unit includes 2 to 30 substructures, and furthermore, one first microstructure unit may include 5 to 15 substructures.

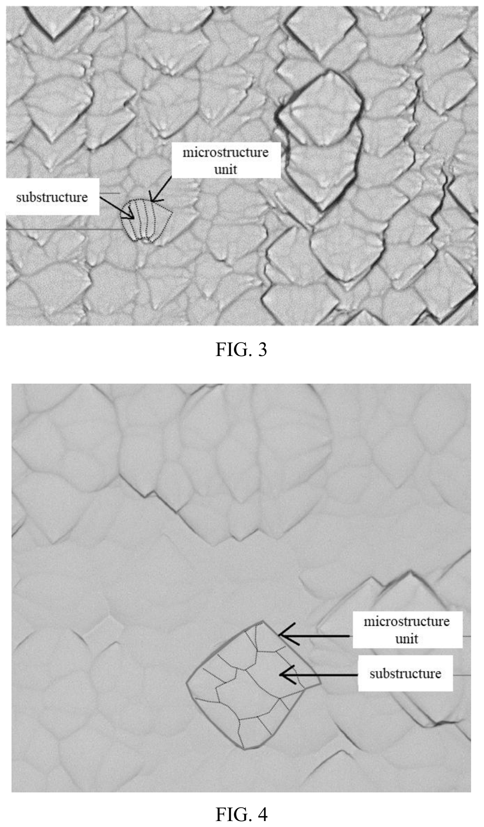

In this embodiment, material of the silicon substrate100 is single-crystalline silicon, and in other embodiments, the materials of the silicon substrate 100 are selected from the group of polycrystalline silicon, microcrystalline silicon, silicon carbide, and the like. FIG. 2 is a microscopic image of a surface of a silicon substrate 100 provided by the present application, FIG. 3 is a microscopic image of a microstructure unit provided by the present application, and FIG. 4 is a schematic diagram of a first microstructure unit and a substructure contained herein provided by the present application.

It should be understood that a term "microstructure unit" in this application, when not explicitly limited to "first microstructure unit", is intended to include a first microstructure unit provided with a substructure and/or a general microstructure unit without a substructure.

As shown in FIG. 2 to FIG. 4, the microstructure unit exhibits a convex-platform shape, with its top forming a top surface. The top surface is planar or approximately planar (exhibiting some recesses if a substructure exists). The top surface of the microstructure unit is used to be in contact with the film-layer structure. In the present application, a preset plane is defined for the microstructure unit. The preset plane is parallel to the silicon substrate 100 (that is, perpendicular to the thickness direction of the silicon substrate 100), and the microstructure unit lies on the preset plane (that is, the preset plane passes through the microstructure unit).

A projection pattern of the microstructure unit on the preset plane is a polygon or a polygon-like, that is, the microstructure unit appears as a polygon or a polygon-like when viewed from a perspective perpendicular to the silicon substrate 100 (that is, a top-down view). As shown in FIG. 2, the projection pattern of the microstructure unit on the preset plane may be a quadrilateral, for example, a rhombus. In other embodiments, the projection pattern of the microstructure unit on the preset plane may be a triangle, a trapezoid, a pentagon, a hexagon, or other shapes. In an embodiment, a perimeter of the projection pattern of the microstructure unit on the preset plane ranges from 10 µm to 500 µm.

In this embodiment, at least a portion of the plurality of microstructure units are adjacent to each other on the preset plane, and/or at least a portion of the plurality of microstructure units partially overlap each other in a thickness direction of the substrate, to obtain an upper microstructure unit and an lower microstructure unit. It should be understood that the upper microstructure unit covers a portion of a top surface of the lower microstructure unit, while another portion of the top surface of the lower microstructure unit is exposed. For example, in the embodiment shown in FIG. 2, a portion of the plurality of microstructure units partially overlap with adjacent microstructure units. In a case that there are partial overlaps between the plurality of microstructure units, it means that the microstructure unit may achieve a higher distribution density, and the surface of the silicon substrate 100 shows greater roughness and a larger surface area, thereby improving an adhesion effect between the silicon substrate 100 and the film-layer structure.

In this embodiment, the plurality of microstructure units are arranged in columns along a preset direction, and a plurality of columns of microstructure units are parallel to each other. For example, an arrow direction in FIG. 2 is the preset direction, which is parallel to the silicon substrate 100.

In the first microstructure unit, a projection pattern of the substructure on the preset plane is a polygon or a polygon-like, and a perimeter of the projection pattern of the substructure on the preset plane ranges from 1 µm to 100 µm. Furthermore, in some embodiments, the perimeter of the projection pattern of the substructure on the preset plane ranges from 15 µm to 40 µm.

In this embodiment, at least a portion of the plurality of substructures are adjacent to each other on the preset plane, so that interfaces between the substructures are formed on the top surface of the microstructure unit. It should be understood that the interface of two adjacent substructures can form a recess on the top surface of the microstructure unit. The recess may be, for example, a crevice between adjacent substructures, signifying that continuity of the top surface of the microstructure unit is broken. A width of the recess is much smaller than a size of the substructure, and may even be at an atomic level.

In a first microstructure unit, the plurality of substructure are arranged in a straight line, as shown in FIG. 3; or, the plurality of substructure are randomly arranged, as shown in FIG. 4; or, the plurality of substructure are arranged along a circumference direction of the first microstructure unit to form a cluster. In an embodiment, a portion of the plurality of substructures of the microstructure unit are arranged in the thickness direction of the silicon substrate 100.

Existence of the substructure is capable of improving passivation performance, reducing the contact resistivity, and improving effective reflectivity of an incident light, thereby optimizing performance of the solar cell in a plurality of aspects. Following examples, based on a plurality of test results, illustrate an optimization effect of the existence of the substructure on the performance of the solar cell.

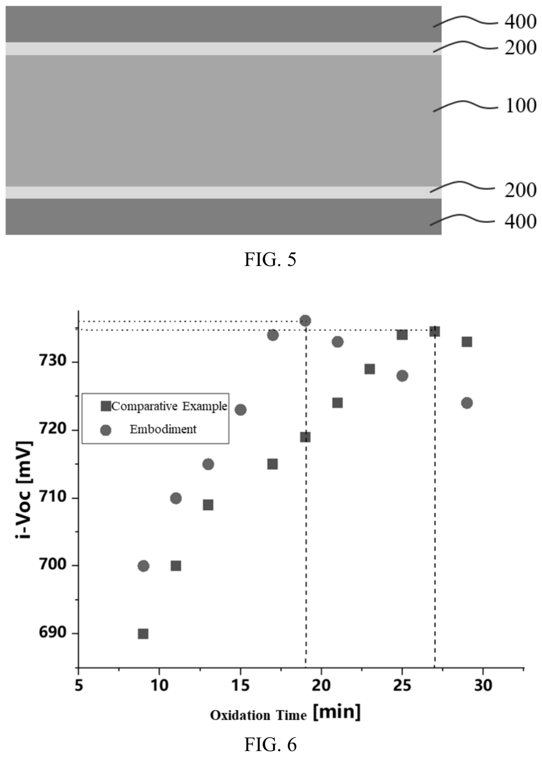

FIG. 5 is a schematic diagram of a first test structure provided by the present application. FIG. 6 is a comparison diagram of i-Voc performance when a silicon substrate 100 with a substructure and a silicon substrate 100 without a substructure are applied to a first test structure. As shown in FIG. 5, the first test structure includes the silicon substrate 100, a dielectric layer 200 and an n-type doped layer 400 disposed on two sides of the silicon substrate 100, and the dielectric layer 200 is disposed between the n-type doped layer 400 and the silicon substrate 100. Among them, the silicon substrate 100 is n-type single-crystal silicon, the n-type doped layer 400 is polycrystalline silicon, and the dielectric layer 200 is silicon oxide. The surfaces of the silicon substrates 100 in both the embodiments and comparative examples are provided with the microstructure units. A difference is that the microstructure unit of the embodiments possess the substructure (that is, the first microstructure unit), while the microstructure unit of the comparative examples does not possess the substructure. As can be seen from FIG. 6, the substructure is beneficial for a growth of high-quality oxide. Consequently, a high-quality dielectric layer 200 may be obtained in the embodiments, which in turn is beneficial for the passivation effect on the surface of the silicon substrate 100, thereby improving the passivation performance of the solar cell, and increasing an implied open-circuit voltage i-Voc of the solar cell.

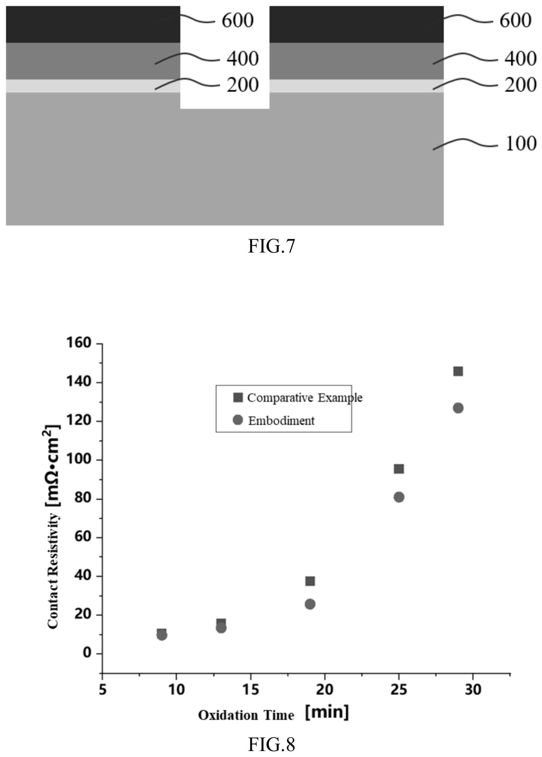

FIG. 7 is a schematic diagram of a second test structure provided by the present application. FIG. 8 is a performance comparison diagram when a silicon substrate 100 with a substructure and a silicon substrate 100 without a substructure are applied to a second test structure. As shown in FIG. 7, the second test structure includes the silicon substrate 100 and two electrodes 600 disposed on a same side of the silicon substrate 100. The two electrodes 600 are spaced apart from each other. The two electrodes 600 are connected to the silicon substrate 100 via the n-type doped layer 400 and the dielectric layer 200, respectively. The n-type doped layer 400 is polysilicon, the dielectric layer 200 is silicon oxide, the silicon substrate 100 is n-type single-crystal silicon, and material of the electrode 600 is silver. The dielectric layer 200 and the n-type doped layer 400 are formed on the silicon substrate 100 by single-sided growth, an Ag electrode 600 is printed on a top of the n-type doped layer 400, and a contact resistivity of the dielectric layer 200 is tested using a transmission line model (TLM) method. With reference to FIG. 8, the silicon substrate 100 in the embodiments is provided with the first microstructure unit (that is, the microstructure unit possessing the substructure), while the microstructure unit on the silicon substrate 100 in the comparative examples does not possess the substructure. Experimental results in FIG. 8 show that the solar cell of the embodiments exhibits a lower contact resistivity, and ultimately demonstrates a higher filling factor. In particular, in view of microstructure optimization of a polysilicon layer (that is, the n-type doped layer 400), by designing the first microstructure unit to possess the substructure, surface roughness and specific surface area of the polysilicon layer are increased, doping concentration of impurity atoms is increased, and thereby achieving the lower contact resistivity.

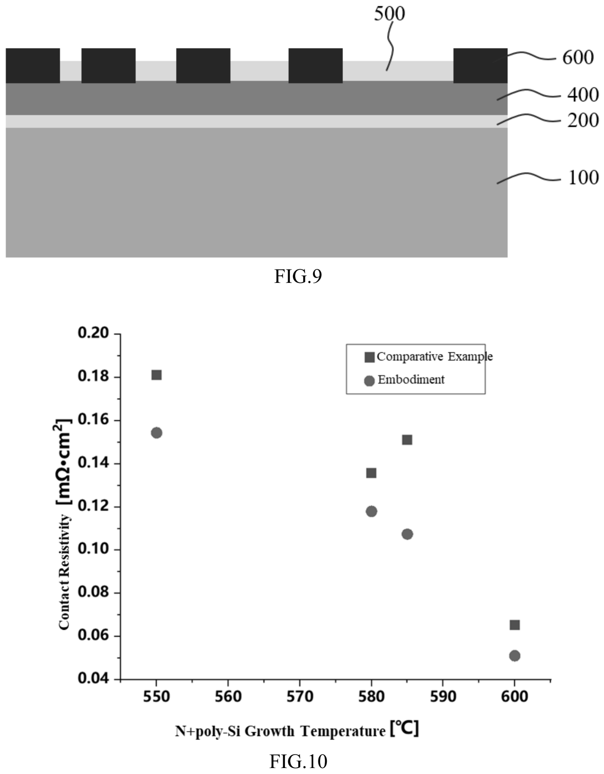

FIG. 9 is a schematic diagram of a third test structure provided by the present application. FIG. 10 is a performance comparison diagram when a silicon substrate 100 with a first microstructure unit and a silicon substrate 100 without a first microstructure unit are applied to a third test structure. As shown in FIG. 9, the third test structure includes the silicon substrate 100, the dielectric layer 200, and the n-type doped layer 400 stacked in sequence. A passivation layer 500 and a plurality of electrodes 600 spaced apart from each other are disposed on a side of the n-type doped layer 400 away from the silicon substrate 100. Among them, the n-type doped layer 400 is polysilicon, the dielectric layer 200 is silicon oxide, the silicon substrate 100 is n-type single-crystal silicon, and the material of the electrode 600 is silver. The third test structure is used for testing a contact resistivity between the electrode 600 and the n-type doped layer 400. FIG. 10 shows contact resistivity test results between the electrode 600 and the n-type doped layer 400 in conditions of different silicon substrate 100. The microstructure unit on the surface of the silicon substrate 100 in the embodiments is provided with the substructure (that is, the microstructure unit is the first microstructure unit), while the microstructure unit on the silicon substrate 100 in the comparative examples is not provided with the substructure. The surface of the silicon substrate 100 provided with the first microstructure unit is rougher, and the roughness of the silicon substrate 100 affects the roughness of a surface of the n-type doped layer 400, that is, the rougher the surface of the silicon substrate 100, the higher the roughness of the surface of the n-type doped layer 400. A larger roughness of the surface of the n-type doped layer 400 results in a larger specific surface area. Consequently, a relative doping amount of the n-type doped layer 400 is also higher, a contact resistivity of a grown n-type doped layer 400 will be lower, and thereby reducing a metalsemiconductor contact resistivity between the n-type doped layer 400 and the electrode 600.

In addition, the silicon substrate 100 provided with the first microstructure unit may also improve the effective reflectivity of the incident light. Due to a larger specific surface area of the silicon substrate 100, incident rays may be more effectively scattered and absorbed inside a solar cell, collection probability of a photogenerated carrier is increased, thereby improving a shortcircuit current density.

Referring to FIG. 1 again. In this embodiment, the microstructure units may be distributed on a portion, covered by the film-layer structure, of the surface of the silicon substrate 100, or distributed on all surfaces, covered by the film-layers, of the silicon substrate 100. In the embodiment shown in FIG. 1, the microstructure units are distributed across the first surface 101 and the second surface 102 on the back side of the silicon substrate 100. A surface on the light-receiving side of the silicon substrate 100 is textured surface. Furthermore, the microstructure unit on the second surface 102 is provided with the plurality of substructures. The plurality of substructure on the second surface 102 may effectively increase roughness of the second surface 102, thereby enhancing a passivation effect of the second dielectric layer 220, reducing a contact resistivity between the second dielectric layer 220 and the silicon substrate 100, and reducing a contact resistivity between the n-type doped layer 400 and the second electrode 620.

In at least on embodiment as shown in FIG. 1, materials of the first passivation layer 510 and the second passivation layer 520 are selected from at least one of aluminum oxide, silicon oxide, silicon nitride, or silicon oxynitride.

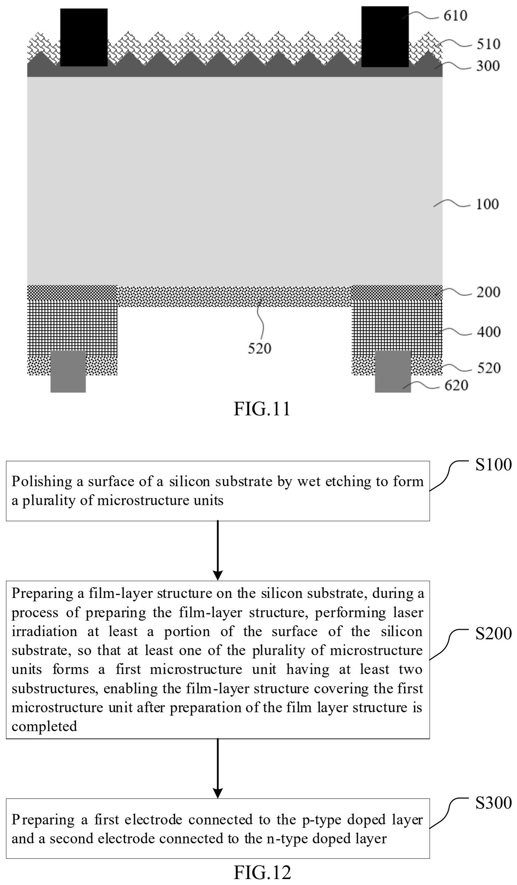

The embodiment described in FIG. 1 is illustrated based on a back contact solar cell. In the present application, the solar cell may also be other types of solar cell structures, such as a tunnel-oxide-passivating-contact (TOPCon) solar cell, a silicon heterointerface solar cell, and the like. FIG. 11 is a schematic diagram of a solar cell provided by a second embodiment of the present application.

As shown in FIG. 11, the solar cell provided in this embodiment is the TOPCon solar cell. The solar cell includes a silicon substrate 100, a film-layer structure disposed on a surface of the silicon substrate 100, and an electrode 600 connected to the film-layer structure. In this embodiment, the silicon substrate 100 is provided with a light-receiving side and a back side opposite to each other in a thickness direction of the silicon substrate. As shown in FIG. 11, an upper side is the light-receiving side of the silicon substrate 100, and a lower side is the back side of the silicon substrate 100. The film-layer structure includes a p-type doped layer 300, an n-type doped layer 400, a dielectric layer 200, a first passivation layer 510, and a second passivation layer 520. The p-type doped layer 300 is disposed on the light-receiving side of the silicon substrate 100, and the first passivation layer 510 is disposed on a side of the p-type doped layer 300 away from the silicon substrate 100. The surface of the back side of the silicon substrate 100 includes a metallized region and a non-metallized region. The dielectric layer 200 and the n-type doped layer 400 are stacked on the metallized region of the back side in sequence, and the second passivation layer 520 is disposed on the non-metallized region and located on a side of the n-type doped layer 400 away from the silicon substrate 100. It should be understood that in the embodiments of the present application, the metallized region of the back side of the silicon substrate 100 refers to a region covered by the n-type doped layer 400, and the non-metallized region of the back side of the silicon substrate 100 refers to a region on the back side, not covered by n-type doped layer 400, of the silicon substrate 100. The dielectric layer 200 and the n-type doped layer 400 are stacked in the thickness direction of the silicon substrate 100 in sequence.

In the embodiment shown in FIG. 11, the surface of the back side of the silicon substrate 100 is provided with a plurality of microstructure units, among them, the microstructure unit provided with a substructure is located in the non-metallized region.

In the embodiment shown in FIG. 11, the silicon substrate 100 is n-type single-crystalline silicon, and materials of the first passivation layer 510 and the second passivation layer 520 are selected from at least one of aluminum oxide, silicon oxide, silicon nitride, or silicon oxynitride.

It may be understood that in the embodiments of the TOPCon solar cell provided in the present application, similar to the aforementioned back contact solar cell, the microstructure unit and the substructure on the silicon substrate can be formed by a plurality of implementation methods and can achieve corresponding technical effects. Detailed illustration can be referred to in the above recited embodiments. To avoid repetition, details are not described herein again.

FIG. 12 is a flowchart of a preparing method for a solar cell provided by an embodiment of the present application. As shown in FIG. 12, the preparing method for the solar cell provided in the embodiment of the present application may be used for preparing the solar cell provided in the above embodiment. The preparing method includes following steps:
step S 100: polishing a surface of a silicon substrate 100 by wet etching to form a plurality of microstructure units.

step S200: preparing a film-layer structure on the silicon substrate 100, during a process of preparing the film-layer structure, performing laser irradiation at least a portion of the surface of the silicon substrate 100, so that at least one of the plurality of microstructure units forms a first microstructure unit having at least two substructures, enabling the film-layer structure covering the first microstructure unit after preparation of the film layer structure is completed.

Exemplarily, through laser irradiation, an internal stress may be generated in the microstructure unit, causing the microstructure unit cracking, and thereby forming a plurality of substructures and cracks between adjacent substructures. The cracks constitute recesses at an interface between adjacent substructures. This method offers relatively lower processing difficulty, enabling easier production of the substructures, and the recesses formed between the substructures may exhibit smaller dimensions (even reaching an atomic level).

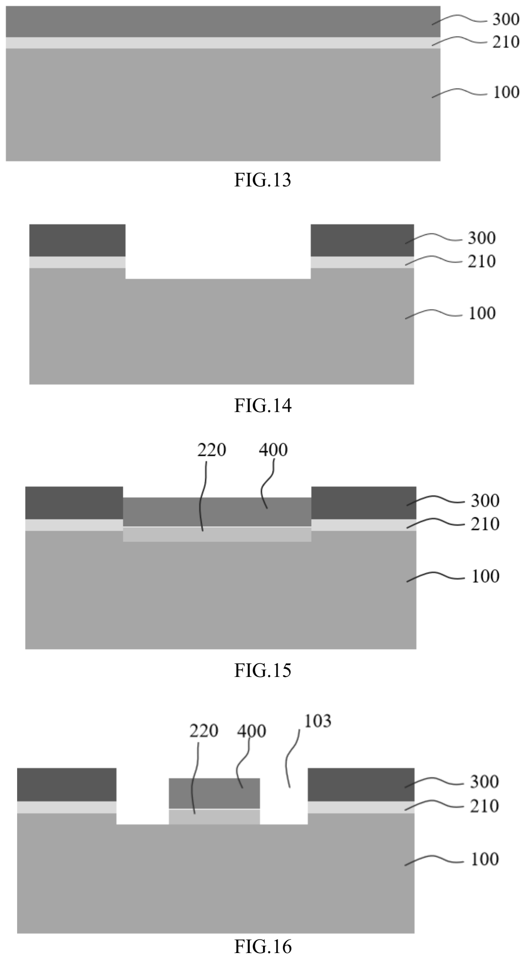

FIG. 13 to FIG. 17 are schematic diagrams of different phases of a solar cell in a preparing process provided by an embodiment of the present application. Taking preparation of the back contact solar cell provided in the embodiment of FIG. 1 as an example, step S200 may specifically include following steps:
step a1: preparing a first dielectric layer 210 and a p-type doped layer 300 on a back side of the silicon substrate 100 in sequence.

After obtaining the silicon substrate 100 provided with the microstructure unit, the first dielectric layer 210 and the p-type doped layer 300 are firstly fabricated on the back side of the silicon substrate 100 to obtain a structure shown in FIG. 13. It should be noted that in FIG. 13, the light-receiving side of the silicon substrate 100 is on the lower side, and the back side is on the upper side. Specifically, step a1 may be achieved using a low pressure chemical vapor deposition (LPCVD) process. Firstly, the silicon substrate 100 is placed in a LPCVD equipment, and high-purity oxygen is introduced to grow the first dielectric layer 210 at a temperature range of 400°C to 650°C. Subsequently, high-purity SiH4 is introduced to grow an intrinsic polysilicon layer at a temperature range of 450°C to 700°C. The above structure is placed in a boron diffusion furnace tube, where BCl3 is introduced at a temperature range of 750°C to 1050°C for boron diffusion, to transform the intrinsic polysilicon layer into a p-type polysilicon layer, thereby obtaining the p-type doped layer 300.

step a2: removing a portion of the first dielectric layer 210 and a portion of the p-type doped layer 300 using a first laser to expose a portion of the surface of the silicon substrate 100.

After step a2, a structure shown in FIG. 14 is obtained. Optionally, the first laser can be selected from the group of a nanosecond laser, a picosecond laser, or a femtosecond laser, all with a wavelength range of 200 nm to 1300 nm, and an energy density of the first laser ranges from 100 mJ/cm² to 600 mJ/cm².

step a3: performing irradiation on an exposed surface on the back side of the silicon substrate 100 using a second laser, so that at least one of the plurality of microstructure units on the exposed surface of the silicon substrate 100 forms the first microstructure unit having at least two substructures.

In the embodiment of the present application, the exposed surface on the back side of the silicon substrate 100 is irradiated by using the second laser, the plurality of substructures may be formed in each microstructure unit of at least a portion of microstructure units on this surface (that is, these microstructure units are transformed into the first microstructure units), and adjacent interfaces of at least a portion of the plurality of substructures are presented on a top surface of the microstructure unit, thereby increasing roughness and specific surface area of the top surface of the microstructure unit.

Optionally, the second laser is an ultraviolet picosecond laser or an ultraviolet femtosecond laser, and an energy density of the second laser ranges from 20 mJ/cm² to 100 mJ/cm². An ablation depth of the second laser ranges from 10 nm to 100 nm below the surface of the silicon substrate 100, and single crystal silicon in this depth range is subjected to laser heating treatment, thereby forming the plurality of substructures distributed at least on the top surface of the microstructure unit, and further increasing the roughness of the top surface of the microstructure unit and even the surface of the silicon substrate 100.

step a4: preparing a second dielectric layer 220 and an n-type doped layer 400 on the exposed surface of the silicon substrate 100 in sequence.

Optionally, before performing step a4, a structure obtained in step a3 may be cleaned using an alkali solution with a volume concentration range of 0.5% to 5% and a hydrogen peroxide solution with a volume concentration range of 2% to 15%, followed by acid washing (the acid washing solution is hydrochloric acid with a volume concentration range of 4% to 10%, or hydrofluoric acid with a volume concentration ranging from 1% to 10%, or a mixture of both).

In this embodiment, step a4 may specifically include: placing a previously obtained structure in the LPCVD equipment, introducing high-purity oxygen to grow the second dielectric layer 220 at a temperature range of 400°C to 650°C, then using high-purity SiH4 to grow an intrinsic polysilicon layer at a temperature range of 450°C to 700°C. Subsequently, placing the above structure in a phosphorus diffusion furnace tube and using POCl3 to diffuse phosphorus atoms at a temperature range of 850°C to 950°C to transform the intrinsic polysilicon layer into an n-type polysilicon layer, thereby obtaining the n-type doped layer 400. After step a4, a structure shown in FIG. 15 may be obtained.

step a5: etching and forming a trench 103 using a third laser to separate the p-type doped layer 300 from the n-type doped layer 400, and a bottom of the trench 103 extending to the silicon substrate 100.

Types and parameters of the third laser used in step a5 may refer to the first laser, and details are not be described herein again. A structure formed after step a5 is shown in FIG. 16. It should be understood that the third laser may etch away only a portion of the n-type doped layer 400 and a portion of the second dielectric layer 220 to form the trench 103; or the third laser may also etch away a portion of the p-type doped layer 300, a portion of the first dielectric layer 210, a portion of the n-type doped layer 400, and a portion of the second dielectric layer 220 to form the trench 103; or the third laser may etch away only a portion of the p-type doped layer 300 and a portion of the first dielectric layer 210 to form the trench103.

step a6: preparing a first passivation layer 510 on the light-receiving side of the silicon substrate 100, and preparing second passivation layers 520 on the surface of the n-type doped layer 400, on a surface of the p-type doped layer 300, and at the bottom of the trench 103.

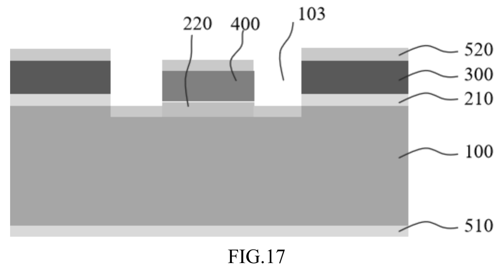

A structure obtained after step a6 is shown in FIG. 17. In this embodiment, the first passivation layer 510 may be a single-layer structure or a composite layer structure, and thus step a6 may be achieved through one or more devices and processes.

In a specific embodiment, an atomic layer deposition process is used for depositing an aluminum oxide layer on the light-receiving side of the silicon substrate 100, that is, the aluminum oxide layers are deposited on the surface of the n-type doped layer 400, on the surface of the p-type doped layer 300, and at the bottom of the trench 103. A plasma enhanced chemical vapor deposition (PECVD) process is used for depositing silicon oxynitride layers on the surface of the n-type doped layer 400, on the surface of the p-type doped layer 300, and at the bottom of the trench 103. The aluminum oxide layer and the silicon oxynitride layer together constitute the second passivation layer 520. The PECVD process is used for preparing a silicon oxide layer, a silicon oxynitride layer, and a silicon nitride layer in sequence on the aluminum oxide layer on the light-receiving side of the silicon substrate 100, and the aluminum oxide layer, the silicon oxide layer, the silicon oxynitride layer, and the silicon nitride layer on the light-receiving side of the silicon substrate 100 together constitute the first passivation layer 510.

In the embodiments of the present application, the preparing method for the solar cell also includes forming a textured surface on the light-receiving side of the silicon substrate 100. A step of texturing the light-receiving side may be performed after step a5 and before step a6. For example, a HF floating-cleaning device is used for removing boron-phosphorus-silicon glass from the silicon substrate 100, and in a tank device, a volume ratio of 7:1 sodium hydroxide and an additive of model TS40 are used, with a temperature maintained at 80°C for 7 minutes, for quickly texturing the silicon substrate 100, and a thinning thickness is controlled at 5µm.

In the above embodiment, a step of using the second laser to form the substructure is interleaved in steps of preparing the film-layer structure. In other embodiments, after completing step S 100 and before depositing the film-layer structure, the second laser may be used for scanning the surface of the back side of the silicon substrate 100 to form the substructure in the microstructure unit. This ensures that the microstructure unit on the second surface 102 corresponding to the p-type doped layer 300 is also provided with the substructure.

In the embodiments of the present application, the preparing method for the solar cell also includes:
step S300: preparing a first electrode 610 connected to the p-type doped layer 300 and a second electrode 620 connected to the n-type doped layer 400.

Optionally, the second electrode 620 is printed on a region of the second passivation layer 520 corresponding to the n-type doped layer 400, and the second electrode 620 is dried in a drying oven at a temperature of 100°C to 300°C. Thereafter, the first electrode 610 is printed on a region of the second passivation layer 520 corresponding to the p-type doped layer 300. Finally, the first electrode 610 and the second electrode 620 are sintered at a peak sintering temperature of 700°C to 900°C. Ultimately, the solar cell as shown in FIG. 1 may be obtained.

After a preparing process is completed, light injection may be performed, specifically including following steps:
1) performing a first heating on electrodes (including the first electrode 610 and the second electrode 620), where a peak temperature of the first heating ranges from 180°C to 620°C;
2) performing a second heating on the electrodes and performing illumination, where a peak temperature of the second heating ranges from 80°C to 320°C, an energy density of the illumination ranges from 12 kW/m² to 120 kW/m², and a wavelength of the illumination ranges from 500 nm to 1100 nm in a continuous spectrum band.

The above steps a1 to a6 represent a preparation method for the back contact solar cell shown in the embodiment of FIG. 1. For other types of the solar cell, adaptive adjustments may be made according to actual conditions. For example, for the TOPCon solar cell shown in FIG. 11, step S200 may specifically include following steps:
step b1: preparing a p-type doped layer 300 on the light-receiving side of the silicon substrate 100.

Specific implementation of step b1 may refer to a method for preparing the p-type doped layer 300 in step a1.

step b2: preparing a dielectric layer 200 and an n-type doped layer 400 on a back side of the silicon substrate 100 in sequence.

Detailed implementation of step b2 may refer to a method for preparing the second dielectric layer 220 and the n-type doped layer 400 in step a4. In a specific embodiment, gas N₂O with a gas purity of 4.2 may firstly be introduced into a reaction chamber. The dielectric layer 200 is prepared under conditions of a pressure of 1200 mTorr to 2400 mTorr and a temperature of 400° C to 450°C. SiH4, PH3, and H2 with a gas purity of 4.2 are introduced, and the n-type doped layer 400 is prepared under conditions of a pressure of 2800 mTorr to 3500 mTorr and a temperature of 400°C to 450°C. Annealing is performed at a temperature of 800°C to 950°C to convert n-type doped amorphous silicon into n-type doped polycrystalline silicon.

step b3: removing a portion of the dielectric layer 200 and a portion of the n-type doped layer 400 using a first laser to expose a non-metallized region of the silicon substrate 100.

Specific implementation of step b3 may refer to a step in step a2 where the first laser is used for removing a portion of the first dielectric layer 210 and a portion of the p-type doped layer 300 to expose the silicon substrate 100.

step b4: performing irradiation on a surface of the non-metallized region using a second laser, so that at least one of the plurality of microstructure units on the surface of the non-metallized region forms the first microstructure unit provided with at least two substructures.

Specific implementation of step b4 may refer to a step in step a3 where the second laser is used for scanning the silicon substrate 100.

step b5: preparing a first passivation layer 510 on a side of the p-type doped layer 300 away from the silicon substrate 100, and preparing second passivation layers 520 on a side of the non-metallized region, and on a side of the n-type doped layer 400 away from the silicon substrate 100.

Detailed implementation of step b5 can refer to a method for preparing the first passivation layer 510 and the second passivation layer 520 in step a6. Specifically, an aluminum oxide layer with a thickness of 3nm to 10 nm may be deposited on the p-type doped layer 300 using an atomic layer deposition process or a PECVD process, and a silicon nitride layer with a thickness of 75nm to 120 nm may be deposited via the PECVD on the aluminum oxide layer on the light-receiving side of the silicon substrate 100, on the back side of the n-type doped layer 400, and on the non-metallized region.

Subsequently, the first electrode 610 connected to the p-type doped layer 300 and the second electrode 620 connected to the n-type doped layer 400 are fabricated, the solar cell as shown in FIG. 11 is obtained. After fabrication is completed, light injection may be performed according to a light injection method described previously.

The embodiments of the present application also provide a photovoltaic module (not shown in the drawings), which includes the solar cell provided by the aforementioned embodiments of the present application or the solar cell fabricated by the preparing method of the aforementioned embodiments.

In summary, the embodiments of the present application provide a solar cell. The solar cell includes the silicon substrate and the film-layer structure disposed on the surface of the silicon substrate. At least a portion, covered by the film-layer structure, of the surface of the silicon substrate is provided with a plurality of microstructure units, and each of at least a portion of the plurality of microstructure units is provided with at least two substructures. The plurality of microstructure units is capable of forming a surface with certain undulations, thereby increasing a bonding area between the film-layer structure and the silicon substrate, and reducing a contact resistivity of the film-layer structure. Furthermore, each microstructure unit is provided with at least two substructures, so that a side of the microstructure unit facing the film-layer structure has greater roughness, thereby further increasing a contact area, reducing the contact resistivity, and also improving the passivation performance of the film layer. Existence of the substructure further increases the surface area of the silicon substrate, and also improves the effective reflectivity of the incident light, enabling the light to be effectively scattered and absorbed inside the solar cell, increasing the collection probability of photogenerated carrier, and thereby improving a shortcircuit current density. Therefore, it may be seen that the embodiments of the present application optimize surface morphology of the silicon substrate, thereby optimizing a plurality of aspects of the solar cell and further enhancing photoelectric conversion efficiency.

The preparing method for the solar cell provided by the embodiment of the present application includes using a laser to form a substructure in a microstructure unit, thereby improving the photoelectric conversion efficiency of the solar cell.

The photovoltaic module provided by the embodiments of the present application includes the aforementioned solar cell or the solar cell fabricated by the aforementioned preparing method.

The above descriptions are only specific implementations of the present application, but the protection scope of the present application is not limited to this. Any person skilled in the art may easily think of changes or replacements within the technical scope disclosed by the present application, which should be covered by the protection scope of the present application.

## Claims

1. A solar cell, wherein the solar cell is a back contact solar cell or a TOPCon solar cell, and the solar cell comprises:
a silicon substrate (100) provided with a light-receiving side and a back side opposite to each other in a thickness direction of the silicon substrate (100); and
a film-layer structure disposed on a surface of the back side of the silicon substrate (100), at least a portion, covered by the film-layer structure, of a surface of the silicon substrate (100) being provided with a plurality of microstructure units, the plurality of microstructure units comprising at least one first microstructure unit, and each first microstructure unit of the at least one first microstructure unit being provided with at least two substructures; wherein
in a case that the solar cell is the back contact solar cell, the surface of the back side of the silicon substrate (100) comprises an n-type doped region and a p-type doped region, and the first microstructure unit is located in the n-type doped region; or
in a case that the solar cell is the TOPCon solar cell, the surface of the back side of the silicon substrate (100) comprises a metallized region and a non-metallized region, and the first microstructure unit is located in the non-metallized region.

2. The solar cell according to claim 1, wherein in the first microstructure unit, an interface of each two of the at least two substructures is presented on a top surface, facing towards a side of the film-layer structure, of the first microstructure unit.

3. The solar cell according to claim 1, wherein a projection pattern of the microstructure unit on a preset plane is a polygon or a quasi-polygon, a perimeter of the projection pattern of the microstructure unit on the preset plane ranges from 10 µm to 500 µm, and the preset plane is parallel to the silicon substrate (100).

4. The solar cell according to claim 1, wherein a projection pattern of the substructure on a preset plane is a polygon or a quasi-polygon, a perimeter of the projection pattern of the substructure on the preset plane ranges from 1 µm to 100 µm, and the preset plane is parallel to the silicon substrate (100).

5. The solar cell according to claim 1, wherein in the first microstructure unit,
a plurality of substructures are arranged along a straight-line direction, or
a plurality of substructures are arranged along a circumference direction of the first microstructure unit to form a cluster, or
a plurality of substructures are randomly arranged.

6. The solar cell according to claim 1, wherein
at least a portion of the plurality of microstructure units are adjacent to each other on a preset plane; and/or
at least a portion of the plurality of microstructure units partially overlap each other in a thickness direction of the substrate;
wherein the preset plane is parallel to the silicon substrate (100).

7. The solar cell according to any one of claims 1 to 6, wherein the solar cell is the back contact solar cell, and the n-type doped region and the p-type doped region are separated by a trench (103); and
the film-layer structure comprises a p-type doped layer (300), an n-type doped layer (400), a first dielectric layer (210), and a second dielectric layer (220), the first dielectric layer (210) and the p-type doped layer (300) are stacked on the p-type doped region in sequence, the second dielectric layer (220) and the n-type doped layer (400) are stacked on the n-type doped region in sequence, and the first microstructure unit is located in the n-type doped region.

8. The solar cell according to claim 7, wherein a first passivation layer (510) is disposed on the light-receiving side of the silicon substrate (100), and second passivation layers (520) are disposed at a bottommost of the trench (103), on a side of the p-type doped layer (300) away from the silicon substrate (100), and on a side of the n-type doped layer (400) away from the silicon substrate (100).

9. The solar cell according to any one of claims 1 to 6, wherein the solar cell is the TOPCon solar cell, the film-layer structure comprises a p-type doped layer (300), an n-type doped layer (400), and a dielectric layer (200), the p-type doped layer (300) is disposed on a light-receiving side of the silicon substrate (100), and the dielectric layer (200) and the n-type doped layer (400) are stacked on the metallized region in sequence.

10. The solar cell according to claim 9, wherein a first passivation layer (510) is located on a side of the p-type doped layer (300) away from the silicon substrate (100), and second passivation layers (520) are located at a back side of the non-metallized region and on a side of the n-type doped layer (400) away from the silicon substrate (100).

11. A preparing method for a solar cell, comprising:
polishing a surface of a silicon substrate (100) by wet etching to form a plurality of microstructure units; and
preparing a film-layer structure on the silicon substrate (100), wherein, performing laser irradiation on at least a portion of the surface of the silicon substrate (100), so that at least one of the plurality of microstructure units forms a first microstructure unit having at least two substructures, and the film-layer structure covering the first microstructure unit after preparation of the film-layer structure is completed.

12. The preparing method for the solar cell according to claim 11, wherein the silicon substrate (100) is provided with a light-receiving side and a back side opposite to each other in a thickness direction of the silicon substrate (100), and the preparing the film-layer structure on the silicon substrate (100), before or during the process of preparing the film-layer structure, performing laser irradiation on at least a portion of the surface of the silicon substrate (100), so that at least one of the plurality of microstructure units forms the first microstructure unit provided with at least two substructures comprises:
preparing a first dielectric layer (210) and a p-type doped layer (300) on the back side of the silicon substrate (100) in sequence;
removing a portion of the first dielectric layer (210) and a portion of the p-type doped layer (300) using a first laser to expose a portion of the surface of the silicon substrate (100);
performing irradiation on an exposed surface of the silicon substrate (100) using a second laser, so that at least one of the plurality of microstructure units on the exposed surface of the silicon substrate (100) forms the first microstructure unit provided with at least two substructures;
preparing a second dielectric layer (220) and an n-type doped layer (400) on the exposed surface of the silicon substrate (100) in sequence;
etching and forming a trench (103) using a third laser to separate the p-type doped layer (300) from the n-type doped layer (400), and the trench (103) extending to the silicon substrate (100); and
preparing a first passivation layer (510) on the light-receiving side of the silicon substrate (100), and preparing second passivation layers (520) on a side of the n-type doped layer (400) away from the silicon substrate (100), on a side of the p-type doped layer (300) away from the silicon substrate (100), and at a bottom of the trench (103).

13. The preparing method for the solar cell according to claim 11, wherein the silicon substrate (100) is provided with a light-receiving side and a back side opposite to each other in a thickness direction of the silicon substrate (100), and the preparing the film-layer structure on the silicon substrate (100), before or during the process of preparing the film-layer structure, performing laser irradiation on at least a portion of the surface of the silicon substrate (100), so that at least one of the plurality of microstructure units forms the first microstructure unit provided with at least two substructures comprises:
preparing a p-type doped layer (300) on the light-receiving side of the silicon substrate (100);
preparing a dielectric layer (200) and an n-type doped layer (400) on the back side of the silicon substrate (100) in sequence;
removing a portion of the dielectric layer (200) and a portion of the n-type doped layer (400) using a first laser to expose a non-metallized region of the silicon substrate (100);
performing irradiation on the non-metallized region using a second laser, so that at least one of the plurality of microstructure units in the non-metallized region forms the first microstructure unit provided with at least two substructures; and
preparing a first passivation layer (510) on a side of the p-type doped layer (300) away from the silicon substrate (100), and preparing second passivation layers (520) on the non-metallized region and on a side of the n-type doped layer (400) away from the silicon substrate (100).

14. The preparing method for the solar cell according to claim 12 or claim 13, wherein
the first laser is a nanosecond laser, a picosecond laser, or a femtosecond laser, all with a wavelength range of 200 nm to 1300 nm, and an energy density of the first laser ranges from 100 mJ/cm² to 600 mJ/cm²; and/or,
the second laser is an ultraviolet picosecond laser or an ultraviolet femtosecond laser, and an energy density of the second laser ranges from 20 mJ/cm² to 100 mJ/cm².

15. A photovoltaic module, comprising the solar cell according to any one of claims 1 to 10, or comprising the preparing method for the solar cell according to any one of claims 11 to 14.
